# EUROPEAN PATENT SPECIFICATION

(11) **EP 2 790 238 B1**
(45) Date of publication and mention of the grant of the patent: **22.08.2018**
(21) Application number: 13163215.0
(22) Date of filing: 10.04.2013
(51) Int. Cl.: H01L 51/05

(54) **Organic field effect transistor and method for production**
Organischer Feldeffekttransistor und Herstellungsverfahren
Transistor à effet de champ organique et procédé de production

(43) Date of publication of application: 15.10.2014
(73) Proprietor: Novaled GmbH, 01307 Dresden (DE)
(72) Inventor: Kleemann, Hans, Dipl.-Phys., 01099 Dresden (DE); Lüssem, Björn, Dr.-Ing., 44240 Kent (US); Leo, Karl, Prof. Dr., 01219 Dresden (DE)
(74) Representative: Bittner, Thomas L.

(56) References cited:
- WO-A1-2011/134959
- DE-U1-202005 009 260
- US-A1- 2010 096 625
- TADA K ET AL: "CHARACTERISTICS OF JUNCTION DEVICES UTILIZAING C60 DOPED CONDUCTING POLYMER", TECHNOLOGY REPORTS OF THE OSAKA UNIVERSITY, OSAKA, JP, vol. 45, no. 2224, 15 October 1995 (1995-10-15), pages 161-166, XP008001972,
- HIROYUKI IECHI ET AL: "Organic Inverter Using Monolithically Stacked Static Induction Transistors", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 49, no. 1 pt.2, 1 January 2010 (2010-01-01), pages 1AB12-1, XP001551697, ISSN: 0021-4922, DOI: 10.1143/JJAP.49.01AB12 [retrieved on 2010-01-20]

## Description

The invention refers an organic filed effect transistor and a method for production.

### Background

Ever since the invention of organic field effect transistors (OFETs) in the 1980s their performance could be continuously improved. Nowadays, OFETs are used for driving e-ink displays, printed RFID tags, and flexible electronics. The advantages of OFETs compared to silicon technology are the possibility to realize thin and flexible circuits at low process temperatures on large areas. Despite this progress, the widespread application of OFETs is still limited due to their low performance and stability. However, there is a large potential for improvement by the development of advanced OFET structures.

There are different types of transistor structures known, such as inversion FET (IFET), depletion FET (DFET) or junction FET (JFET). All those structures may be realized as an organic FET. In general, an organic field effect transistor comprises a gate electrode, a source electrode and a drain electrode. In general, the OFET comprises an organic semiconductor and a gate insulator which separates the gate electrode from the organic semiconductor and which is made of an inorganic material.

The organic doping technology has been shown to be a useful technology for highly efficient opto-electronic devices such as organic light emitting devices or organic solar cells. The use of doped organic layers in organic transistors has also been proposed. For example, doping can be used to reduce the contact resistance at the source and drain contacts. A thin p- or n-doped layer between the metallic contact and the organic semiconductor forms an ohmic contact which increases the tunnel currents and enhances the injection.

It has been reported that the threshold voltage can be shifted by the doping concentration. Meijer et al. Journal of Applied Physics, vol. 93, no. 8, p. 4831, 2003, studied the effect of doping by oxygen exposure on polymer transistors. Although a shift of the switch-on voltage (the flatband voltage) was observed, the effect was not related to doping by the authors. Similarly, other authors found a similar shift of threshold voltage with applying a dopant, but often this effect is rather related to the influence of contact doping than to channel doping.

Inversion FETs are normally OFF and an inversion channel has to be formed by an applied gate voltage in order to switch the transistor ON. Inversion FETs are used in silicon CMOS circuits and are the most basic building block of all integrated circuits. It is known that the inversion regime cannot be reached in organic MIS (metal insulator semiconductor) capacitors. However, it has been predicted by simulations that an inversion channel can be formed in FET structures, if minority carriers are injected at the source and drain electrodes. Huang et al. Journal of Applied Physics, vol. 100, no. 11, p. 114512, 2006, could show that a normally n-conducting intrinsic material can be made p-conductive by charging the gate insulator prior to deposition of the organic layer by a corona discharge.

An organic metal semiconductor field effect transistor is proposed in Braga et al. Adv. Material, 2010, 22, 424-428.

Document US 2010 / 0096625 A1 discloses an organic field effect transistor comprising a substrate on which a source and a drain electrode are arranged. A semiconducting layer is deposited on top of the electrodes and in electrical contact with the electrodes. The semiconducting layer is formed with a lower sublayer and an upper sublayer. On top of the upper sublayer a dielectric layer and a gate electrode are provided. The semiconductor materials of the semiconducting layer may contain inorganic particles such as nanotubes or conductive silicon filaments. The lower and upper sublayer can be n-type or p-type and can have doping of the same kind.

In document US 5,629,530 a field effect transistor with a source region, a drain region and a interposed n-type channel region is disclosed. The channel region is provided with a gate electrode that is separated from the channel region by an insulating layer.

An organic thin film transistor is described in document US 2006 / 0033098 A1. The transistor comprises a substrate, a gate electrode, a gate dielectric layer which covers the entire gate electrode, a source electrode, a drain electrode, an active channel layer and a source interfacial layer. A potential barrier between the source electrode and the active channel layer is reduced by adding an agent into the active channel layer.

The document EP 2 194 582 A1 describes an organic thin film transistor with a substrate, a gate electrode, a source electrode, a drain electrode, an insulator layer, an organic semiconducting layer and a channel control layer that is arranged between the organic semiconducting layer and the insulator layer. The channel control layer includes an amorphous organic compound having an ionization potential of less than 5,8 eV.

In document US 2003 / 0092232 A1 a further field effect transistor is disclosed.

Document WO 2011/134959 A1 discloses an organic field effect transistor. The transistor comprises a substrate, a bottom gate electrode deposited on the substrate and a gate insulating layer arranged over the gate electrode. An organic semiconducting material is arranged on the gate insulating layer to form a channel layer. A spacer layer is formed on the channel layer comprising at least one organic semiconducting spacer material. An n-doped material and optionally an organic electron transport material are deposited on the spacer layer to form a dopant layer. Finally, a conductive material is arranged on the dopant layer to form source and drain electrodes.

Document DE 20 2005 009 260 U1 discloses another organic field effect transistor having a source and drain electrode as well as a gate electrode. The source electrode, drain electrode and gate electrode are arranged adjacant to a layer of an organic semiconducting material. The organic semiconducting material is electrically doped.

Document K.Tada, et. al. "Characteristics of Junction devices utilizing C60 doped conducting polymer", technology reports of the Osaka University, Vol. 45, no. 2224, pages 161 to 166 (1995) discloses Schottky diodes and Schottky gated field effect transistors with C₆₀ doped conducting polymers. The characteristics of the devices are strongly depended on the concentration of the C₆₀ dopant.

Document H. Iechi, et. al., "Organic inverter using monolithically stacked static induction transistors", Japanese Journal of Applied Physics, Vol. 49, 01AB12 (2010) discloses a monolithic organic inverter with a stacked structure of two organic static induction transistors.

### Summary

It is an object of the invention to provide an organic field effect transistor with optimized working parameters and a method for producing the transistor.

An organic field effect transistor according to claim 1 and a method for producing an organic field effect transistor according to claim 13 are provided. Advantageous embodiments of the invention are the subject of dependent claims.

According to one aspect, an organic field effect transistor is provided. The transistor comprises a first electrode and a second electrode, the electrodes providing a source electrode and a drain electrode. There is a gate electrode. Also, an electronically active region is provided, the electronically active region being made at least in part of an organic material and providing a charge carrier channel. There is a gate electrode separation covering and separating the gate electrode. The gate electrode separation comprises an electrically doped organic semiconducting layer directly provided on the gate electrode, wherein the doped organic semiconducting layer comprises an organic matrix material and an organic electrical dopant.

According to another aspect, a method for producing an organic field effect transistor is provided, comprising steps of providing a substrate, and depositing a layered structure on the substrate. The layered structure is produced with a first electrode and a second electrode, the electrodes providing a source electrode and a drain electrode, a gate electrode, an electronically active region at least in part made of an organic material and providing a charge carrier channel, and a gate electrode separation, comprising a doped organic semiconducting layer directly provided on the gate electrode, wherein the doped organic semiconducting layer comprises an organic matrix material and an organic dopant.

The transistor may implement a junction OFET.

In the transistor, the gate electrode separation may be provided as a multilayer separator.

The gate electrode separation as whole may be made of organic material(s). It may be provided free of an inorganic insulator.

The transistor may comprise an additional doped organic semiconducting layer, the additional or further doped organic semiconducting layer comprising an organic matrix material and an organic dopant and being provided between the doped organic semiconducting layer and the first and second electrode. The additional doped organic semiconducting layer may be provided adjacent to the first and second electrode. It may be in direct contact with at least one of the first electrode and the second electrode.

The doped organic semiconducting layer may provided with a first type of electrical doping, and the additional doped organic semiconducting layer may be provided with a second type of electrical doping which is different from the first type of electrical doping. The first type of electrical doping may be an n-type doping or a p-type doping. The second type of electrical doping may be a p-type doping or an n-type doping.

In addition to the doped organic semiconducting layer and the additional doped organic semiconducting layer, at least one other doped organic semiconducting layer may be provided. The at least one other electrically doped organic semiconducting layer may be implemented as contact improving layer providing improved electrical (injection) contact between the material of the first and / or the material of the second electrode and a layer adjacent to the contact improving layer within the electronically active region.

The transistor may further comprise an intrinsic semiconducting layer. The term "intrinsic" as used here refer to an un-doped semiconducting layer which is not electrically doped.

The intrinsic semiconducting layer may be provided between the doped organic semiconducting layer and the additional doped organic semiconducting layer.

The intrinsic semiconducting layer may be provided in direct contact with at least one of the doped organic semiconducting layer and the additional doped organic semiconducting layer. The intrinsic semiconducting layer may completely separate the doped organic semiconducting layer and the additional doped organic semiconducting layer. A pin-layer structure, e.g. a pin-diode, may be provided by the doped organic semiconducting layer, the intrinsic layer and the additional doped organic semiconducting layer. The term "pin" refers to a layer structure made of a p-doped semiconducting layer, an intrinsic layer and an n-doped semiconducting layer.

The intrinsic semiconducting layer may be an organic intrinsic semiconducting layer made of an organic material. An organic pin-layer structure may be provided.

The intrinsic semiconducting layer may be provided with a layer thickness of about 10 nm to about 50 nm, preferably of about 20 nm to about 40 nm.

At least one of the doped organic semiconducting layer and the additional doped organic semiconducting layer may be provided with a layer thickness of about 2 nm to about 50 nm preferably of about 4 nm to about 20 nm.

The transistor may comprise an electrode pattern, the electrode pattern providing at least one of the first and second electrode and the gate electrode with an electrode structure, and providing a non-overlapping electrode pattern for the gate electrode on one hand and the first and second electrode on the other hand. Looking at the device plane the gate electrode does not overlap with both the first and the second electrode. In the process of device production, the electrode pattern may be produced by using a shadow mask technology and / or a lithography technology.

The materials of the gate electrode as well as the first and second electrode may be deposited by vacuum thermal evaporation (VTE). Alternatively, the electrode materials may be ink-jet printed while applying a conductive paste. Preferably, the layers of the OFET, namely at least one of the gate electrode, the first electrode, the second electrode, the intrinsic semiconducting layer, the doped organic semiconducting layer, and the additional doped organic semiconducting layer may be structured by using shadow mask technology. Alternatively or supplementary, the layers of the OFET can be structured by optical lithography. The organic material for the intrinsic semiconducting layer may be deposited by thermal evaporation under ultra high vacuum (UHV) conditions. The organic material of the intrinsic semiconducting layer may be deposited prior to the deposition of the other electrode material of the first and second electrode using the same shadow mask. Herewith, an efficient injection of charge carriers at the first and second electrode is ensured. Alternatively, the organic field effect transistor can be produced by solution based methods such as blade coating, spin coating and spray coating. Preferably, the transistor is produced by roll-to-roll coating.

At least one electrode selected from the following group may be made of a metallic material: the first electrode, the second electrode, and the gate electrode. The gate electrode can be formed by metals such as Al, Au, Ag, Ti, Pt, for example. If the first and / or second electrode shall inject electrons it may be formed by metals with a low work function, e.g. Ti or Al. If the first and / or second electrode shall inject holes it/they may be formed by metals with a large work function, e.g. Au, Ag, ITO.

The intrinsic semiconducting layer and the doped organic semiconducting layer(s) may comprise the same organic matrix material. Alternatively, the intrinsic organic semiconducting layer and the doped organic semiconducting layer(s) may comprise different matrix materials.

The organic dopant is a dopant made of an organic material. It is preferably an electrical dopant. Providing an electrical organic dopant in a matrix material leads to a charge transfer between the dopant and the matrix material. Electrical dopants are classified in p-dopants (oxidation reaction) and n-dopants (reduction reaction). Electrical doping is well known in the field, exemplary literature references are Gao et al, Appl. Phys. Lett. V.79, p.4040 (2001), Blochwitz et al, Appl. Phys. Lett. V.73, p.729 (1998), D'Andrade et al. App. Phys. Let. V.83, p. 3858 (2003), Walzer et al. Chem. Rev. V. 107, p.1233 (2007), US 2005 / 040390 A1, US 2009 / 179189 A. Preferred p-doping compounds are organic molecules containing cyano groups.

The organic dopant may be spatially distributed in the matrix material of the doped organic semiconducting layer instead of being accumulated at an interface of the layer. The distribution of the dopant may be homogeneous along the dimensions of the layer. The matrix material (host) / dopant system may be chosen with respect to the energy levels of a matrix and a dopant material. For a preferable combination of host and dopant the activation energy required for doping is less than the 50 meV. Such activation energy can be determined by temperature dependent capacitance-voltage measurements. Low activation energy is preferable since this guarantees a temperature independent threshold voltage of the inversion FET.

Exemplary p-dopants are:
- tetrafluoro-tetracyanoquinonedimethane (F4TCNQ),
- 2,2'-(perfluoronaphthalene-2,6-diylidene) dimalononitrile,
- 2,2',2"- (cyclopropane-1,2,3-triylidene)tris(2-(p-cyanotetrafluorophenyl)acetonitrile), and
- 2,2',2"-(cyclopropane-1,2,3-triylidene)tris(2-(2,6-dichlor-3,5-difluor-4-(trifluormethyl)phenyl)acetonitrile),
- 2,2',2"-(cyclopropane-1,2,3-triylidene)tris(2-(perfluorphenyl)acetonitrile),
- 2,2',2"-(cyclopropane-1,2,3-triylidene)tris(2-(2,6-dichloro-3,5-difluoro-4-(trifluormethyl)phenyl)-acetonitrile), and
- 3,6-difluoro-2,5,7,7,8,8-hexacyanoquinodimethane (F2CN2TCNQ or F2-HCNQ).

Exemplary n-dopants are:
- acridine orange base (AOB),
- tetrakis (1,3,4,6,7,8 - hexahydro - 2H - pyrimido [1,2-a] pyrimidinato)ditungsten (II) (W2(hpp)4),
- 3,6-bis-(dimethyl amino)-acridine, and
- bis(ethylene-dithio) tetrathiafulvalene (BEDT-TTF).

Preferable host-dopant combinations are (Table 1):

| matrix material (host) | dopant |
|---|---|
| N4,N4,N4',N4'-tetrakis(4-methoxyphenyl)biphenyl-4,4'-diamine (Meo-TPD) | 2,2'-(perfluoronaphthalene-2,6-diylidene)dimalononitrile (F6-TCNNQ) |
| Meo-TPD | F4-TCNQ |
| Meo-TPD | C60F36 |
| Pentacene | F6-TCNNQ |
| Tris( 1 -phenylisoquinoline)iridium(III) (Ir(piq)3) | F6-TCNNQ |
| Pentacene | F4-TCNQ |
| C60 | W2(hpp)4 |
| C60 | Cr2(hpp)4 |
| C60 | AOB |
| Pentacene | W2(hpp)4 |
| Copper(II)-1,2,3,4,8,9,10,11,15,16,17,18, 22,23,24,25-hexadecafluor-29H,31H-phthalocyanin (F16CuPc) | W2(hpp)4 |

In the electrically doped regions, the dopant may be provided with a concentration of up to 4 wt%, preferably between 0.5 wt% and 4 wt%. More preferably, the dopant concentration may be between 0.5 wt% and 2 wt%.

To reduce parasitic leakage currents in the transistor, the doped organic semiconducting layer(s) may be as thin as possible. On the other hand, it has to be thick enough to form a per-colated layer, more preferably a closed layer, and to control the Fermi Level in the doped organic semiconducting layer.

The intrinsic semiconducting layer is free of an electrical dopant material. The intrinsic semiconducting layer may be made from a single organic material. This material can also be called a matrix material even if no electrical dopant is present.

The intrinsic semiconducting layer and / or the doped organic semiconducting layer(s) may comprise a matrix material having one of the following structures: crystalline, polycrystalline, amorphous and a combination thereof.

### Description of further embodiments

Following further embodiments are described in further detail, by way of example, with reference to figures. In the figures show:
- Fig. 1: a schematic representation of an organic field effect transistor (OFET) of the junction type,
- Fig. 2: a graphical representation of the source current in dependence on the gate-source voltage,
- Fig. 3: a graphical representation of the source current in dependence on the source-drain voltage,
- Fig. 4: a graphical representation of the source current in dependence on the gate voltage,
- Fig. 5: a graphical representation of the current in dependence on the voltage (device characteristic) for pin diodes having an intrinsic layer of different thickness,
- Fig. 6: a graphical representation of the source current in dependence on the source-drain voltage for devices having an intrinsic layer of different thickness, and
- Fig. 7: a graphical representation of the source current in dependence on the source-drain voltage for varying intrinsic layer thickness and p-doped layer thickness.

Following, a structure of an organic field effect structure is described for which the separation of the gate electrode is made of an organic material.

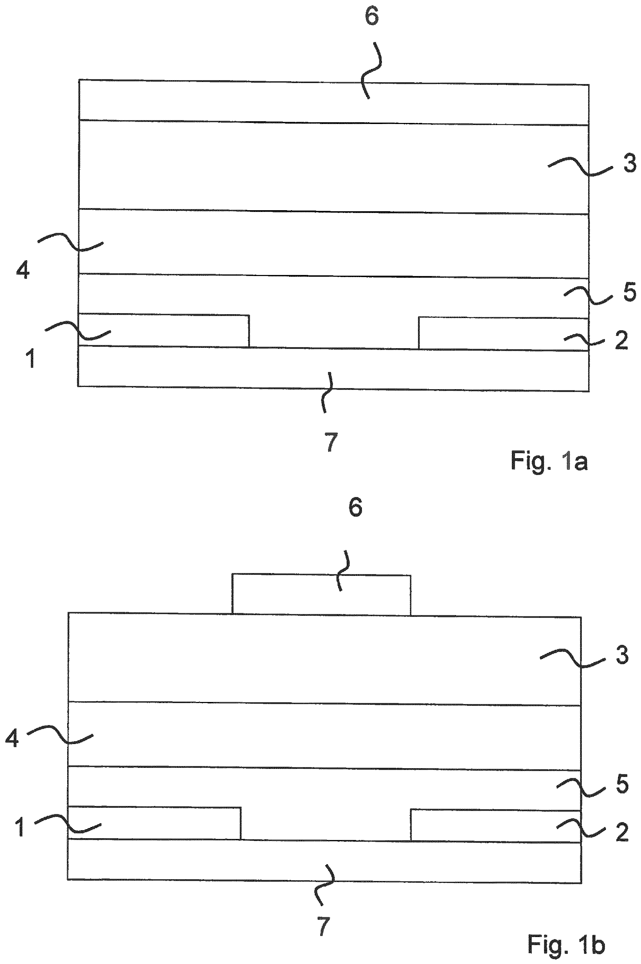

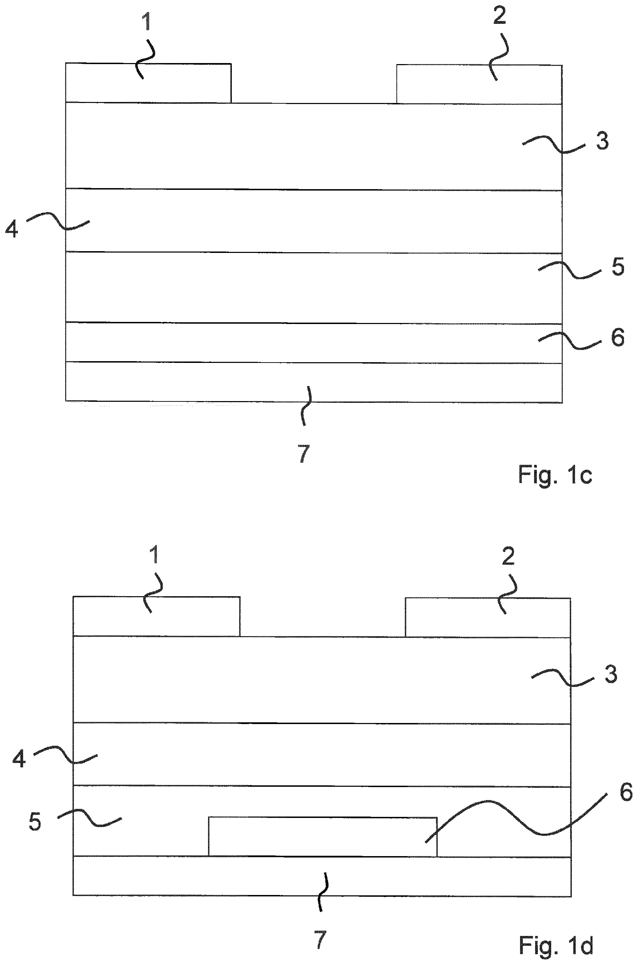

OFET devices of the junction type were prepared according to Fig. 1. Fig. 1a to 1d show different junction OFET (JOFET) device structures.

There are a source electrode 1, a drain electrode 2, and a gate electrode 6. The device comprises a doped organic semiconducting layer 3 and an additional doped organic semiconducting layer 5, both layers being electrically doped. Also, there are an intrinsic layer 4 made of an organic material and a substrate 7. The electrically doped organic semiconducting layers 3, 5 are of opposite polarity, i.e. one of them is p-doped and the other n-doped, thus forming a pin junction. Commonly used metal electrodes such as Ag, Au, Al, Pt, Fe can be used. Due to the doped organic semiconducting layers 3, 5 adjacent to the electrodes, an efficient charge carrier injection is ensured. The organic layers can, for example, be made of pentacene, C60, CuPc, DNTT, BPhen, CBP, MeO-TPD, W2(hpp)4, F6TCNNQ, C60F36, F4TCNQ can be used as dopants.

The JFET shown in Fig. 1a is a top gate bottom contact device. Top contact and bottom gate devices are possible as well (see Fig. 1c). Furthermore, the gate can be structured, so that there is no direct overlap between source electrode 1 or drain electrode 2 or gate electrode 6 (Fig. 1b and 1d). Structuring can be done by shadow masking or optical lithography. The thickness of the intrinsic layer 4 can range from 10nm to 500nm, preferably in the range of 20 to 40nm. The thickness of the doped organic semiconducting layer provided adjacent to the source / drain electrode 1, 2 (layer 5 for structures 1a and 1b or layer 3 for structures 1c, 1d) can range between 2nm and 50nm, preferably between 4nm and 20nm.

On top of the substrate 7 (glass), the gate electrode 6 (60 nm Aluminium) is deposited by thermal evaporation (base pressure < 10⁻⁷ mbar, Fig. 1c). The gate electrode 6 is provided with an electrode structure. There is the additional doped organic semiconducting layer 5 (thickness: 50nm) of BPhen doped with the n-type dopant Cs. The doped organic semiconducting layer 3 provides an electron transporting layer. In addition, there is the intrinsic layer 4 of NPB 4 (thickness: 25nm). Also, there is the additional doped organic semiconducting layer 5 (thickness: 20nm) of pentacene doped with 4 wt% F₆TCNNQ. The source electrode 1 and the drain electrode 2 consist of 30nm Au and 50nm Aluminium, respectively.

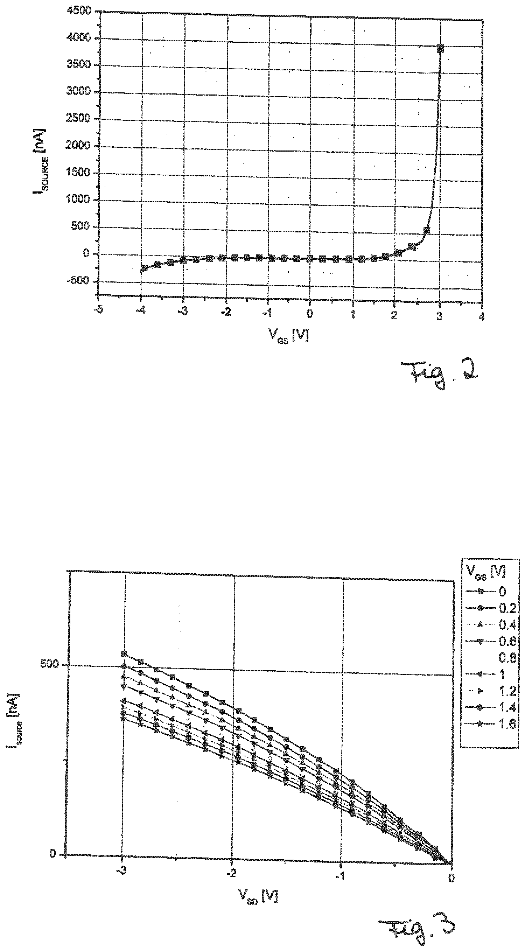

Fig. 2 shows the characteristic of the pin diode consisting of the n-layer (BPhen:Cs), the intrinsic layer (NPB) and the p-doped layer (Pentacene: F₆TCNNQ) measured between the source and the gate electrode 1, 2. As expected, the current rises sharply at positive voltages (∼ 2.5V), but the device blocks at negative voltages. The voltages are applied to the source electrode 1. The gate electrode 6 is kept at ground level.

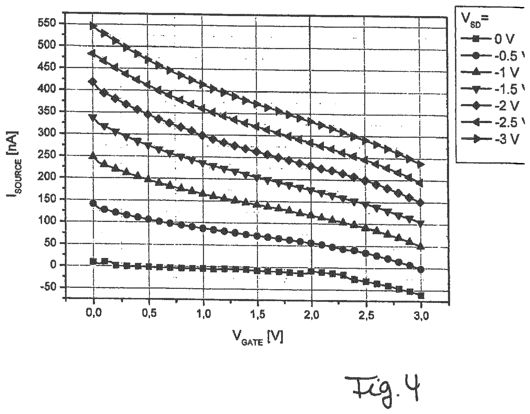

In Fig. 3 the output characteristic, i.e. the source current vs. the source-drain voltage for varying gate voltages of the JFET is shown. It can be seen that the gate electrode 6 modulates the source current, i.e. the transistor behaves as a variable resistor. This can also be seen in Fig. 4 showing the source current is plotted vs. the gate voltage for varying source-drain voltages.

Further, junction FETs with different thickness of the intrinsic layer 4 were prepared.

The thickness of all layers of the JFET described above with respect to Fig. 2 to 4 can be varied. As example, transistors with the same structure as in Fig. 1c but with varying thickness of the intrinsic layer 4 (15nm, 20nm, 25nm) were prepared.

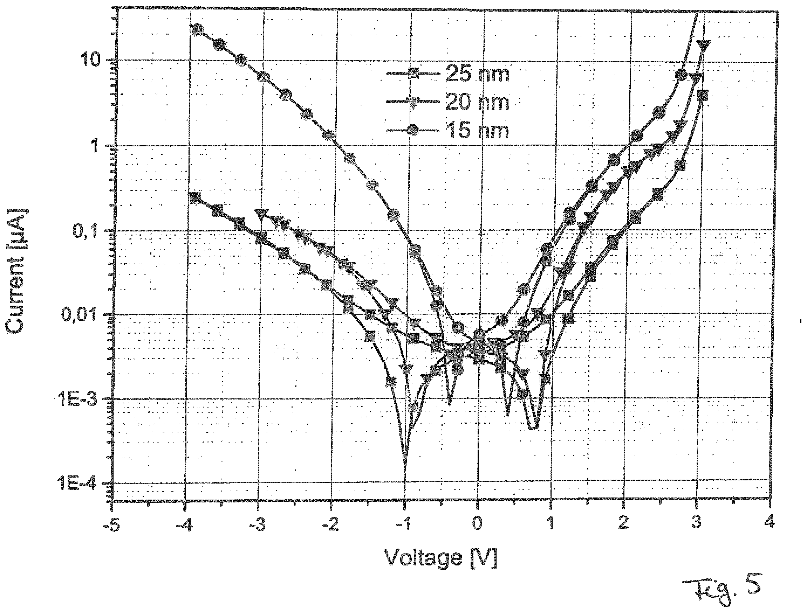

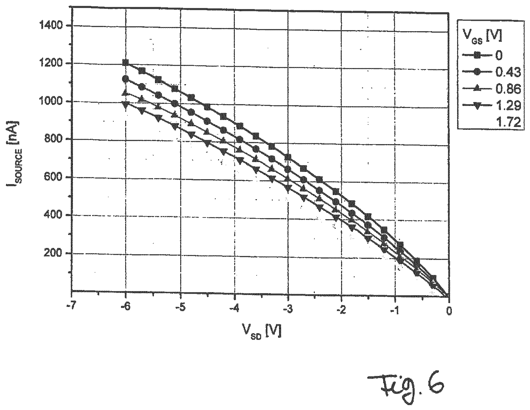

Fig. 5 compares the characteristic of the pin diode of the two structures with 20nm and 25nm intrinsic layer thickness. As expected, the currents in backward direction increase for thinner intrinsic interlayer thickness, which is negative for the JFET performance. Nevertheless, the output characteristic (Fig. 6, 20 nm intrinsic layer thickness) shows that the source current can be modulated by the gate voltage.

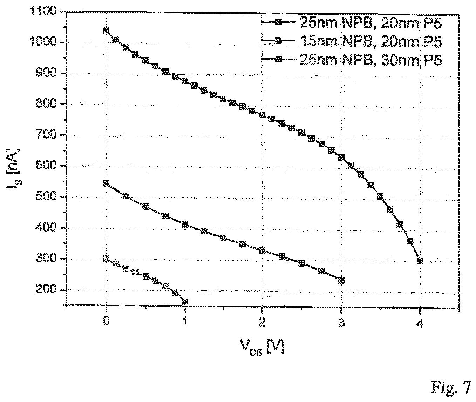

Fig. 7 shows a graphical representation of the source current in dependence on the source-drain voltage. The transfer characteristic at V_{DS}=-3V is shown for a JFET consisting of 25nm NPB and 20nm p-pentacene (the same JFET as discussed above), a JFET having a thinner intrinsic layer thickness (15nm NPB, 20nm p-pentacene) and a JFET with increased pentacene layer thickness (25nm NPB, 30nm p-pentacene). The JFET design corresponds to the one shown in Fig. 1c. The currents decrease for thinner NPB layer, which can be explained by a larger depletion layer thickness for the same gate potential. Furthermore, the gate currents increase and in order to keep the gate currents to an acceptable level, V_{DS} has to be limited to 1V. Increasing the pentacene layer thickness leads to increased currents, which is due to the larger conductance of the layer.

The features disclosed in this specification, the figures and / or the claims may be material for the realization of the invention in its various embodiments, taken in isolation or in various combinations thereof.

## Claims

1. An organic field effect transistor, comprising:
- a first electrode (1) and a second electrode (2), the electrodes providing a source electrode and a drain electrode,
- a gate electrode (6),
- an electronically active region at least in part made of an organic material and providing a charge a carrier channel, and
- a gate electrode separation,
**characterized in that** the gate electrode separation comprises a doped organic semiconducting layer directly provided on the gate electrode (6), wherein the doped organic semiconducting layer comprises an organic matrix material and an organic dopant.

2. The transistor according to claim 1, wherein the gate electrode separation is provided as a multilayer insulation.

3. The transistor according to claim 1 or 2, wherein the gate electrode separation is made of an organic material.

4. The transistor according to at least one of the preceding claims, further comprising an additional doped organic semiconducting layer, the additional doped organic semiconducting layer comprising an organic matrix material and an organic dopant and being provided adjacent to the first and second electrode.

5. The transistor according to claim 4, wherein the doped organic semiconducting layer is provided with a first type of electrical doping, and the further doped organic semiconducting layer is provided with a second type of electrical doping which is different from the first type of electrical doping.

6. The transistor according to at least one of the preceding claims, further comprising an intrinsic semiconducting layer.

7. The transistor according to claim 6, wherein the intrinsic semiconducting layer is provided between the doped organic semiconducting layer and the additional doped organic semiconducting layer.

8. The transistor according to claim 6 or 7, wherein the intrinsic semiconducting layer is provided in direct contact with at least one of the doped organic semiconducting layer and the additional doped organic semiconducting layer.

9. The transistor according to one of the claims 6 to 8, wherein the intrinsic semiconducting layer is an organic intrinsic semiconducting layer made of an organic material.

10. The transistor according to one of the claims 6 to 9, wherein the intrinsic layer is provided with a layer thickness of about 10 nm to about 500 nm.

11. The transistor according to at least one of the preceding claims, wherein at least one of the doped organic semiconducting layer and the additional doped organic semiconducting layer is provided with a layer thickness of about 2 nm to about 50 nm.

12. The transistor according to at least one of the preceding claims, further comprising an electrode pattern, the electrode pattern providing at least one of the first and second electrode and the gate electrode with an electrode structure, and providing a non-overlapping electrode pattern for the gate electrode on one hand and the first and second electrode on the other hand.

13. Method for producing an organic field effect transistor, comprising steps of:
- providing a substrate, and
- providing a layered structure on the substrate, the layered structure comprising
- a first electrode (1) and a second electrode (2), the electrodes providing a source electrode and a drain electrode,
- a gate electrode (6),
- an electronically active region at least in part made of an organic material and providing a charge a carrier channel, and
- a gate electrode separation,
**characterized in that** the gate electrode separation comprises a doped organic semiconducting layer directly provided on the gate electrode (6), wherein the doped organic semiconducting layer comprises an organic matrix material and an organic dopant.

## Patentansprüche

1. Organischer Feldeffekttransistor, umfassend:
- eine erste Elektrode (1) und eine zweite Elektrode (2), wobei die Elektroden eine Source-Elektrode und eine Drain-Elektrode bereitstellen,
- eine Gate-Elektrode (6),
- einen elektronisch aktiven Bereich, der zumindest teilweise aus einem organischen Material hergestellt ist und einen Ladungsträgerkanal bereitstellt, und
- eine Gate-Elektroden-Trennung,
**dadurch gekennzeichnet, dass** die Gate-Elektroden-Trennung eine dotierte organische halbleitende Schicht umfasst, die direkt auf der Gate-Elektrode (6) vorgesehen ist, wobei die dotierte organische halbleitende Schicht ein organisches Matrixmaterial und ein organisches Dotierungsmittel umfasst.

2. Transistor nach Anspruch 1, wobei die Gate-Elektroden-Trennung als mehrschichtige Isolation vorgesehen ist.

3. Transistor nach Anspruch 1 oder 2, wobei die Gate-Elektroden-Trennung aus einem organischen Material hergestellt ist.

4. Transistor nach mindestens einem der vorherigen Ansprüche, der ferner eine zusätzliche dotierte organische halbleitende Schicht umfasst, wobei die zusätzliche dotierte organische halbleitende Schicht ein organisches Matrixmaterial und ein organisches Dotierungsmittel umfasst und angrenzend an die erste und zweite Elektrode vorgesehen ist.

5. Transistor nach Anspruch 4, wobei die dotierte organische halbleitende Schicht mit einem ersten Typ von elektrischer Dotierung versehen ist, und die weitere dotierte organische halbleitende Schicht mit einem zweiten Typ von elektrischer Dotierung versehen ist, die sich vom ersten Typ von elektrischer Dotierung unterscheidet.

6. Transistor nach mindestens einem der vorherigen Ansprüche, der ferner eine intrinsische halbleitende Schicht umfasst.

7. Transistor nach Anspruch 6, wobei die intrinsische halbleitende Schicht zwischen der dotierten organischen halbleitenden Schicht und der zusätzlichen dotierten organischen halbleitenden Schicht vorgesehen ist.

8. Transistor nach Anspruch 6 oder 7, wobei die intrinsische halbleitende Schicht in direktem Kontakt mit mindestens einer Schicht aus der dotierten organischen halbleitenden Schicht und der zusätzlichen dotierten organischen halbleitenden Schicht vorgesehen ist.

9. Transistor nach einem der Ansprüche 6-8, wobei die intrinsische halbleitende Schicht eine organische intrinsische halbleitende Schicht ist, die aus einem organischen Material hergestellt ist.

10. Transistor nach einem der Ansprüche 6-9, wobei die intrinsische Schicht mit einer Schichtdicke von etwa 10 nm bis etwa 500 nm vorgesehen ist.

11. Transistor nach mindestens einem der vorherigen Ansprüche, wobei mindestens eine der dotierten organischen halbleitenden Schicht und der zusätzlichen dotierten organischen halbleitenden Schicht mit einer Schichtdicke von etwa 2 nm bis etwa 50 nm vorgesehen ist.

12. Transistor nach mindestens einem der vorherigen Ansprüche, der ferner ein Elektrodenmuster umfasst, wobei das Elektrodenmuster mindestens eine der ersten und zweiten Elektrode und der Gate-Elektrode mit einer Elektrodenstruktur bereitstellt und ein nicht-überlappendes Elektrodenmuster für die Gate-Elektrode einerseits und die erste und zweite Elektrode andererseits bereitstellt.

13. Verfahren zum Herstellen eines organischen Feldeffekttransistors, das die folgenden Schritte umfasst:
- Bereitstellen eines Substrats; und
- Bereitstellen einer Schichtstruktur auf dem Substrat, wobei die Schichtstruktur umfasst:
- eine erste Elektrode (1) und eine zweite Elektrode (2), wobei die Elektroden eine Source-Elektrode und eine Drain-Elektrode bereitstellen,
- eine Gate-Elektrode (6),
- einen elektronisch aktiven Bereich, der zumindest teilweise aus einem organischen Material hergestellt ist und einen Ladungsträgerkanal bereitstellt, und
- eine Gate-Elektroden-Trennung,
**dadurch gekennzeichnet, dass** die Gate-Elektroden-Trennung eine dotierte organische halbleitende Schicht umfasst, die direkt auf der Gate-Elektrode (6) vorgesehen ist, wobei die dotierte organische halbleitende Schicht ein organisches Matrixmaterial und ein organisches Dotierungsmittel umfasst.

## Revendications

1. Transistor à effet de champ organique, comprenant :
- une première électrode (1) et une seconde électrode (2), les électrodes fournissant une électrode de source est une électrode de drain,
- une électrode de grille (6),
- une région électroniquement active au moins en partie fabriquée à partir d'un matériau organique et fournissant un canal de porteur de charge, et
- une séparation d'électrode de grille,
**caractérisé en ce que** la séparation d'électrode de grille comprend une couche semi-conductrice organique dopée directement montée sur l'électrode de grille (6), dans laquelle la couche semi-conductrice organique dopée comprend un matériau matriciel organique et un dopant organique.

2. Transistor selon la revendication 1, dans lequel la séparation d'électrode de grille est comme une isolation multicouche.

3. Transistor selon la revendication 1 ou la revendication 2, dans lequel la séparation d'électrode de grille est fabriquée à partir d'un matériau organique.

4. Transistor selon l'une quelconque des revendications précédentes, comprenant en outre une couche semi-conductrice organique dopée supplémentaire, la couche semi-conductrice organique dopée supplémentaire comprenant un matériau matriciel organique et un dopant organique et étant montée de manière adjacente à la première et à la seconde électrode.

5. Transistor selon la revendication 4, dans lequel la couche semi-conductrice organique dopée est équipée d'un premier type de dopant électrique, et la couche semi-conductrice organique dopée supplémentaire est équipée d'un second type de dopant électrique qui est différent du premier type de dopant électrique.

6. Transistor selon l'une quelconque des revendications précédentes, comprenant en outre une couche semi-conductrice intrinsèque.

7. Transistor selon la revendication 6, dans lequel la couche semi-conductrice intrinsèque se situe entre la couche semi-conductrice organique dopée et la couche semi-conductrice organique dopée supplémentaire.

8. Transistor selon la revendication 6 ou la revendication 7, dans lequel la couche semi-conductrice intrinsèque est en contact direct avec au moins une de la couche semi-conductrice organique dopée et de la couche semi-conductrice organique dopée supplémentaire.

9. Transistor selon l'une quelconque des revendications 6 à 8, dans lequel la couche semi-conductrice intrinsèque est une couche semi-conductrice intrinsèque organique fabriquée à partir d'un matériau organique.

10. Transistor selon l'une quelconque des revendications 6 à 9, dans lequel la couche intrinsèque possède une épaisseur de couche comprise entre environ 10 nm et environ 500 nm.

11. Transistor selon l'une quelconque des revendications précédentes, dans lequel au moins une de la couche semi-conductrice organique dopée et de la couche semi-conductrice organique dopée supplémentaire possède une épaisseur de couche comprise entre environ 2 nm et environ 50 nm.

12. Transistor selon l'une quelconque des revendications précédentes, comprenant en outre un motif d'électrode, le motif d'électrode fournissant au moins une de la première et de la seconde électrode de grille munie d'une structure d'électrode, et fournissant d'un côté un motif d'électrode non chevauchant pour l'électrode de grille, et de l'autre côté la première et la seconde électrode.

13. Procédé permettant de produire un transistor à effet de champ organique, comprenant les étapes consistant à :
- fournir un substrat, et
- fournir une structure en couches sur le substrat, la structure en couches comprenant
- une première électrode (1) et une seconde électrode (2), les électrodes fournissant une électrode de source est une électrode de drain,
- une électrode de grille (6),
- une région électroniquement active au moins en partie fabriquée à partir d'un matériau organique et fournissant un canal de porteur de charge, et
- une séparation d'électrode de grille,
**caractérisé en ce que** la séparation d'électrode de grille comprend une couche semi-conductrice organique dopée directement montée sur l'électrode de grille (6), dans laquelle la couche semi-conductrice organique dopée comprend un matériau matriciel organique et un dopant organique.
